Europäisches Patentamt

European Patent Office

Office européen des brevets

(11) Veröffentlichungsnummer: **0 091 648**

**A1**

(12) **EUROPÄISCHE PATENTANMELDUNG**

(21) Anmeldenummer: **83103334.5**

(22) Anmeldetag: **06.04.83**

(51) Int. Cl.³: **H 01 F 7/18**

(30) Priorität: **10.04.82 DE 3213515**

(43) Veröffentlichungstag der Anmeldung:
**19.10.83 Patentblatt 83/42**

(84) Benannte Vertragsstaaten:
**BE CH DE FR GB IT LI NL**

(71) Anmelder: **HONEYWELL and PHILIPS MEDICAL
ELECTRONICS B.V.
Stratumsedijk 29c
NL-5611 NB Eindhoven(NL)**

(72) Erfinder: **van Liempd, Christinus, Antoinetta Paulus
Zonnebloemhof 10
NL-5482 RS Schijndel(NL)**

(72) Erfinder: **van Nuland, Robertus Josephus
Piet Heijnlaan 55
NL-5694 CB Breugel(NL)**

(74) Vertreter: **Rentzsch, Heinz et al,
Honeywell Europe S.A. Holding KG Patent- und
Lizenzabteilung Kaiserleistrasse 55
D-6050 Offenbach am Main(DE)**

(54) Erregerschaltung für Magnetventile.

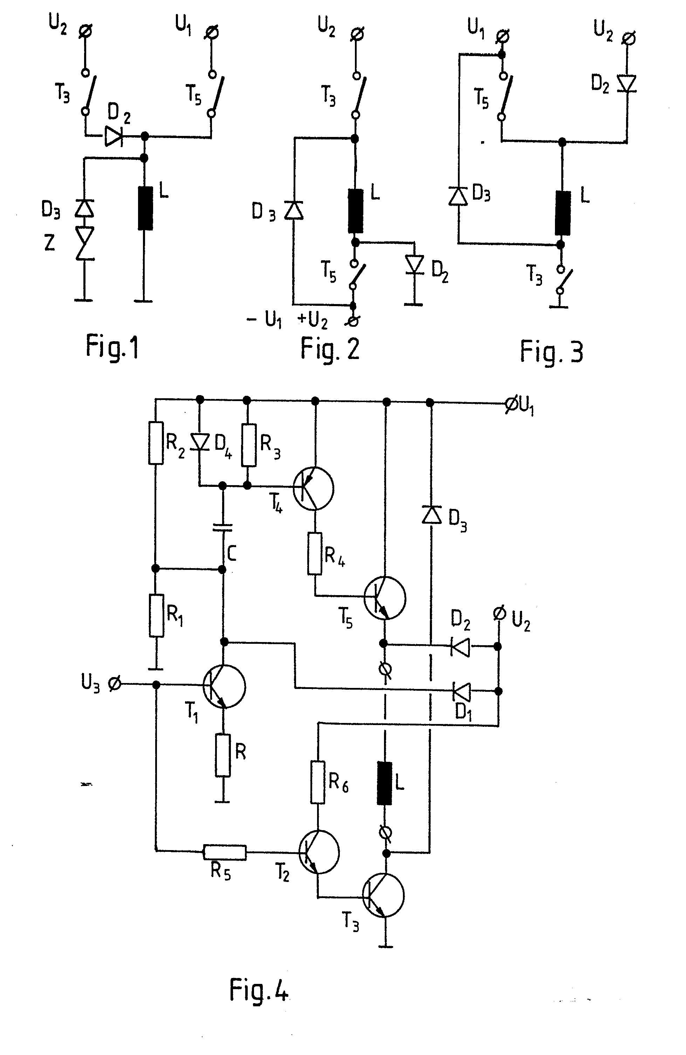

(57) Bei impulsweise erregten Magnetventilen in Dosiereinrichtungen wird einerseits ein schnelles Öffnen und Schließen des Ventils verlangt und andererseits eine möglichst geringe Leistungsaufnahme und Wärmeentwicklung gefordert. Hierzu ist die Erregerspule (L) des Magnetventils über zwei Schaltstrecken ($T_3$, $T_5$) nacheinander zunächst an eine Ansprechstromquelle ($U_1$) höhere Spannung und nach dem Öffnen des Ventils an eine Haltestromquelle ($U_2$) niedrigerer Spannung anschließbar. Die Umschaltung erfolgt entweder durch einen Zeitgeber (R, C, $T_1$) oder durch eine die Lage des beweglichen Magnetkerns des Magnetventils oder seines Schließkörpers abtastende Fühlerschaltung. Bei Verwendung eines Zeitgebers kann dieser als Einzelimpulsgeber einem die Erregerspule (L) mit der Ansprechstromquelle ($U_1$) verbindenden Schalttransistor ($T_5$) vorgeschaltet werden (Fig. 4).

Fig.4

EP 0 091 648 A1

HONEYWELL and PHILIPS
Medical Electronics B.V.
Stratumsedijk 29c
NL-5611 NB Eindhoven
Niederlande

5.April 1983

78100470 EP

HR/ep

Erregerschaltung für Magnetventile

Die Erfindung bezieht sich auf eine Erregerschaltung zum schnellen Betätigen von Magnetventilen, insbesondere Dosierventilen. Beim Dosieren geringer Gasmengen, beispielsweise in Beatmungsgeräten, werden Magnetventile oder Gruppen von Magnetventilen impulsweise für vorgegebene, von der benötigten Gasmenge abhängige Zeitabschnitte abwechselnd geöffnet und geschlossen. Für eine genaue Dosierung ist ein schnelles Öffnen und Schließen der Ventile wichtig, damit eine in ihrem zeitlichen Verlauf weitgehend rechteckförmige Folge von Gasimpulsen vorgegebener Amplitude entsteht. Das gleiche Problem stellt sich beim dosierten Mischen von Gasen sowie beim elektrischen Steuern pneumatischer Antriebe.

Aufgabe der Erfindung ist es, eine ein schnelles Betätigen von Magnetventilen gewährleistende Erregerschaltung zu finden, welche möglichst einfach aufgebaut und zuverlässig im Betrieb ist. Dabei soll zum schnellen Schalten des Magnetventils ein möglichst großer Ansprechstrom die Erregerspule durchfließen, nach dem Öffnen des Magnetventils jedoch der Stromfluß durch die Spule möglichst schlagartig auf den zum Offenhalten des Ventils benötigten geringeren Haltestrom verringert werden. Hierdurch wird einerseits die Wärmeentwicklung in der Erregerspule und andererseits der Leistungsbedarf zum Betrieb des Magnetventils verringert. Diese Aufgabe wird gelöst durch die im Anspruch 1 gekennzeichnete Erfindung. Vorteilhafte Ausgestaltungen ergeben sich aus den Unteransprüchen. In den Ausführungsbeispielen wird das Magnetventil beim Erregen der Spule geöffnet und
bei Wegfall des Erregerstroms durch Federkraft in
bekannter Weise schnell geschlossen. Die Erregerschaltung kann auch im umgekehrten Sinn zum schnellen
Schließen des Ventils benutzt werden, wenn dessen
Schließkörper durch eine Feder oder auf andere
Weise in Öffnungsrichtung vorgespannt ist.

Die Erfindung wird nachfolgend anhand einiger Ausführungsbeispiele erläutert. Dabei zeigt

Fig.1 das Prinzipschaltbild einer ersten Ausführungsform der Erregerschaltung mit
einseitig geerdeter Erregerspule und
Anordnung beider Schaltstrecken auf der
gleichen Seite der Erregerspule;

Fig.2 das Prinzipschaltbild einer Ausführungsform mit zu beiden Seiten der Erregerspule angeordneten Schaltstrecken;

Fig.3 das Prinzipschaltbild einer weiteren
Ausführungsform dieser Art, bei der die
eine Schaltstrecke an Bezugspotential
liegt;

Fig.4 weitere Einzelheiten der Schaltungsanordnung gemäß Fig.3;

Fig.5 den Spannungs- bzw. Stromverlauf an verschiedenen Schaltungspunkten der Schaltungsanordnung gemäß Fig.4.

In Fig.1 ist die einseitig an Masse liegende Erregerspule L über eine hier als Schalter dargestellte,
üblicherweise aber als elektronischer Schalter, beispielsweise Feldeffekttransistor, Thyristor oder
Schalttransistor ausgebildete Schaltstrecke $T_5$ an eine
Ansprechstromquelle $U_1$ von beispielsweise 75V Gleichspannung anschließbar. Diese liefert den Ansprechstrom für die Schnellerregung des Magnetventils. Ferner ist eine Haltestromquelle $U_2$ vorgesehen, welche über eine weitere Schaltstrecke $T_3$ sowie eine für den Haltestrom in Durchlaßrichtung gepolte Diode $D_2'$ an die Erregerspule L anschließbar ist. An und für sich könnten beide Schaltstrecken $T_3$ und $T_5$ abwechselnd geschaltet werden. Um jedoch beim Abschalten des Ansprechstroms, d.h. beim Öffnen der Schaltstrecke $T_5$ keine Lücke in der Stromversorgung für die Spule L entstehen zu lassen, wird beim Schließen der Schaltstrecke $T_5$ auch die Schaltstrecke $T_3$ mit geschlossen. Um einen Stromfluß von der auf höherem Potential liegenden Ansprechstromquelle $U_1$ zur Haltestromquelle $U_2$ zu verhindern, ist die Diode $D_2$ vorgesehen. Die Haltestromquelle hat beispielsweise eine Spannung von 12V Gleichspannung. Um die Transistoren $T_3$ und $T_5$ beim plötzlichen Öffnen der Schaltstrecke $T_3$ gegen die in der Spule L induzierte Spannungsspitze zu schützen, ist der Spule eine Freilaufdiode $D_3$ in Reihe mit einer Zenerdiode Z parallelgeschaltet. Zum Erregen der Spule L werden somit zunächst beide Schaltstrecken $T_3$ und $T_5$ geschlossen, so daß von der Ansprechstromquelle $U_1$ der Ansprechstrom durch die Spule L fließt und den beweglichen Magnetkern in Bewegung setzt. Sobald eine vorgegebene zum Ansprechen des Ventils erforderliche Zeitspanne verstrichen ist oder mittels eines Fühlers festgestellt ist, daß der Magnetkern seine Endposition erreicht hat oder das Ventil geöffnet ist, bewirkt eine Steuerschaltung das Öffnen der Schaltstrecke $T_5$ , so daß nunmehr nur noch über die Schaltstrecke $T_3$ der gegenüber dem Ansprechstrom kleinere Haltestrom zur Erregerspule L fließt. Die Steuergröße zum Beenden des Haltestromflusses kann von einem Lagefühler für den Magnetkern bzw. den Schließkörper des Ventils oder von einem magnetischen Fühler geliefert werden, der die infolge der Bewegung des Magnetkerns innerhalb der Spule in der Spule induzierte Gegen-EMK auswertet. In den meisten Fällen wird jedoch aus Grunden der Schaltungsvereinfachung ein Zeitgeber Verwendung finden, der bei Einschaltung des Ansprechstroms eingeschaltet wird und nach einer vorgegebenen, erfahrungsgemäß für das Ansprechen des Ventils ausreichenden Zeitspanne das Öffnungssignal für die Schaltstrecke $T_5$ liefert. Soll das Magnetventil schließen, so wird auch die Schaltstrecke $T_3$ geöffnet und damit der Stromfluß durch die Spule L unterbrochen. Eine übliche Rückstellfeder bringt den Schließkörper des Ventils in die Schließlage. Die Verwendung einer Haltestromquelle $U_2$ geringerer Spannung im Vergleich zur Ansprechstromquelle $U_1$ hat den zusätzlichen Vorteil, daß die Schließfeder das Ventil beim Abschalten der Haltestromquelle $U_2$ schnell in die Schließlage bewegen kann, weil der Haltestrom wesentlich geringer ist als der ursprünglich eingeschaltete Ansprechstrom aus der Ansprechstromquelle $U_1$. Die Zenerdiode Z bestimmt die Abschaltzeit des Ventils.

Die Schaltungsanordnungen nach den Figuren 2 und 3 arbeiten im Prinzip in gleicher Weise. Abweichend von Fig.1 ist hier je eine Schaltstrecke zu beiden Seiten der Spule L angeordnet. Bei der Ausführungsform gemäß Fig.2 ist der der Schaltstrecke $T_5$ zugewandte Anschluß der Spule L über einen Diode $D_2''$ mit Bezugspotential verbunden, so daß die Ansprechstromquelle $U_1'$ die entgegengesetzte Polarität haben muß wie die Haltestromquelle $U_2$. Beträgt die Spannung $U_2$ zur Erzeugung des Haltestroms widerum 12V und wird für die Erzeugung des Ansprechstroms eine Spannung $U_1 = 75V$ benötigt, so beträgt die Spannung $U_1' = - U_1 + U_2 = -63V$. Diese Schaltung hat gegenüber derjenigen gemäß Fig.1 den Vorteil, daß die dort die Abschaltspannung und damit die Abklingzeit des Stroms auf Null bestimmende Zenerdiode Z in Fig.2 wegfällt und kaum ein Energieverlust auftritt, weil die Abschaltenergie über die

Diode $D_3$ in die Ansprechstromquelle $U_1$' zurückfließt.

Die gleichen Vorteile gelten für die Schaltungsanordnung gemäß Fig.3, welche sich zusätzlich dadurch
als besonders günstig erweist, daß beide Stromquellen
$U_1$ und $U_2$ die gleiche Polarität haben. Diese Ausführungsform der Erregerschaltung und die zugehörige
Steuerschaltung sind in Fig.4 im einzelnen wiedergegeben. Sie stellt eine besonders vorteilhafte
Kombination der Erregerschaltung mit einem die Zeitdauer des Ansprechstromflusses bestimmenden Einzelimpulsgeber dar. Zugleich zeigt sie, daß die Steuerschaltung an übliche MOS-Schaltkreise mit 5V Ausgangsspannung anschließbar ist. Sie benötigt einen Eingangsstrom von weniger als 200µA.

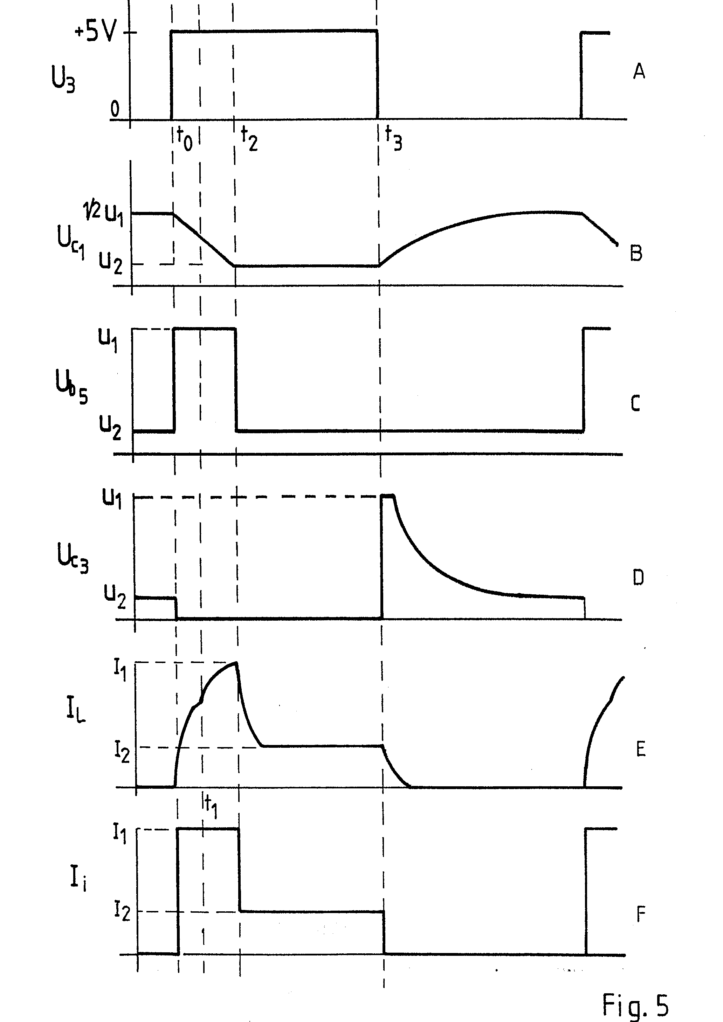

Aufbau und Wirkungsweise dieser Schaltungsanordnung
werden nachfolgend in Verbindung mit Fig.5 beschrieben.

Am Eingang Y dieser Schaltung steht eine impulsförmige
Spannung $U_3$, welche während der gewünschten Einschaltdauer des Magnetventils beispielsweise einen Wert von
5V und sonst den Wert Null hat. Diese Spannung ist in
Fig.5 als Kurve A wiedergegeben. Wie eingangs erwähnt,
soll durch die Spule L im Idealfall ein Strom $I_i$
fließen, der während der Anfangszeit einen höheren Wert,
nämlich der Ansprechstrom $I_1$ hat und nach dem Ansprechen
des Ventils auf den Haltestrom $I_2$ abgesenkt wird. Diese
ideale Stromkurve F ist in Fig.5 in der untersten Zeile
wiedergegeben. Dabei ist das Verhältnis des Ansprechstroms $I_1$ zum Haltestrom $I_2$ aus Gründen der zeichnerischen Darstellung verkleinert wiedergegeben. Mit
der Erregerspule L sind als Schaltstrecken die beiden
Schalttransistoren $T_3$ und $T_5$ in Reihe zwischen Bezugspotential und die Ansprechstromquelle $U_1$ eingeschaltet.
Dabei dienen die als Darlington-Paar geschalteten
Transistoren $T_2$ und $T_3$ dem Anschluß des unteren Spulenendes an Bezugspotential, während der Transistor $T_5$ das obere Spulenende mit der Ansprechstromquelle $U_1$ verbindet. Die Eingangsklemme Y steht einerseits über den Widerstand $R_5$ mit der Basis des Transistors $T_2$ in Verbindung und ist andererseits an die Basis des als Konstantstromquelle dienenden Transistors $T_1$ angeschlossen, der mit einem Widerstand $R_3$ und einem Kondensator C sowie einem Transistor $T_4$, einer Diode $D_4$ und einem Widerstand $R_3$ einen Einzelimpulsgeber bildet. Der Verbindungspunkt des Kollektors des Transistors $T_1$ mit dem Kondensator C ist an den Abgriff eines aus der Ansprechstromquelle $U_1$ gespeisten Spannungsteilers $R_2, R_1$ geführt. Der Kollektor des Transistors $T_4$ liegt über einen Widerstand $R_4$ an der Basis des Transistors $T_5$, dessen Kollektor ebenso wie derjenige des Transistors $T_4$ an die Ansprechstromquelle $U_1$ angeschlossen ist. Der Reiheschaltung der Spule L mit der Kollektor-Emitter-Strecke des Transistors $T_5$ ist eine entgegengesetzt zum Erregerstromfluß gepolte Diode $D_3$ parallelgeschaltet. Der Kollektor des Transistors $T_1$ ist über eine Diode $D_1$ an die Haltestromquelle $U_2$ angeschlossen, welche über eine weitere Diode $D_2$ an die Verbindungsleitung zwischen dem Emitter des Transistors $T_5$ und dem oberen Anschluß der Erregerspule L geführt ist. Der Transistor $T_4$ liefert über den Widerstand $R_4$ den Basissteuerstrom für den Transistor $T_5$.

Bei fehlendem Eingangssignal $U_3$ an der Klemme Y ist der Transistor $T_3$ gesperrt. Der Verlauf seiner Basisspannung entspricht praktisch demjenigen der Eingangsspannung $U_3$. Der Transistor $T_1$ ist ebenfalls gesperrt, so daß die Basis des Transistors $T_4$ über den Widerstand $R_3$ praktisch auf dem Potential der Ansprechstromquelle $U_1$ liegt und der Transistor $T_5$ gesperrt ist. Am Kondensator C steht eine Spannung entsprechend dem Spannungsabfall am Widerstand $R_2$ gegeben durch

$$U_c = \frac{R_1}{R_1 + R_2} U_1$$ . Alle Dioden $D_1$ bis $D_4$ sind gesperrt, wobei vorausgesetzt ist, daß die genannte Spannung $U_c$ am Kondensator größer ist als $U_2$. Wählt man $R_1 = R_2$, so steht am Kondensator C die halbe Ansprechspannung $U_1$ und folglich auch am Kollektor des Transistors $T_1$. Diese Kollektorspannung $U_{c1}$ ist in der Kurve B aufgetragen.

Zur Zeit $t_0$ springt die Eingangsspannung $U_3$ auf einen positiven Wert von beispielsweise 5V, wodurch die Transistoren $T_2$ und $T_3$ bis in ihren Sättigungsbereich durchgeschaltet werden. Die Basisspannung am Transistor $T_3$ folgt wie erwähnt der Spannung $U_3$ während, die Kollektorspannung $U_{c3}$ des Transistors $T_3$ von dem bisher über die Diode $D_2$ anstehenden Wert $U_2$ der Spannung der Haltestromquelle auf Null absinkt. Die Spannung $U_3$ schaltet im Zeitpunkt $t_0$ zugleich den Transistor $T_1$ durch, welcher als Konstantstromquelle den Kondensator C auflädt, wobei seine Kollektorspannung $U_{c1}$, dargestellt in Kurve B, linear abnimmt. Gleichzeitig fällt die Spannung an der Basis des Transistors $T_4$ ab und der Transistor $T_5$ schaltet schlagartig durch. Seine Basisspannung $U_{b5}$ ist in Kurve C wiedergegeben. Er wird bis in den Sättigungsbereich durchgeschaltet und schließt damit die Erregerspule L an die Ansprechstromquelle $U_1$ an. Der Erregerstrom $I_L$ steigt nach einer Exponentialfunktion entsprechend der Kurve E an. Zur Zeit $t_1$ beginnt sich der Magnetkern in der Spule L zu bewegen und damit das Ventil zu öffnen. Der Strom $I_L$ steigt weiter an bis zum Zeitpunkt $t_2$ (vergleiche Kurve B) die Kollektorspannung $U_{c1}$ am Transistor $T_1$ auf den Wert der Spannung $U_2$ der Haltestromquelle abgesunken ist. Nunmehr wird der Transistor $T_1$ über die Diode $D_1$ aus der Haltestromquelle $U_2$ mit Strom versorgt und das Laden des Kondensators C unterbrochen. Damit verschwindet der

Spannungsabfall am Widerstand $R_3$ und der Transistor $T_5$ sperrt. Damit ist die Ansprechstromquelle $U_1$ von der Erregerspule L abgeschaltet und letztere erhält nur noch ihren Haltestrom $I_2$ über die Diode $D_2$ aus der Haltestromquelle $U_2$. Vorausgesetzt wir, daß $\dfrac{U_1 - U_2}{R_2} \quad \dfrac{U_3}{R}$ .

Zur Zeit $t_3$ ist der Eingangsimpuls $U_3$ am Eingang Y beendet, so daß einerseits der Transistor $T_3$ sperrt und damit den Stromfluß durch die Spule L unterbricht. Gleichzeitig beginnt die Kollektorspannung $U_{c1}$ des Transistors $T_1$ auf den Wert $\dfrac{R_1}{R_1 + R_2} U_1$ anzusteigen. Die Diode $D_4$ und der Widerstand $R_3$ schützen den Transistor $T_4$ gegen beim Sperren des Transistors $T_5$ entstehenden Spannungssprung am Kondensator C. Außerdem sorgt der Widerstand $R_3$ für ein schlagartigen Sperren des Transistors $T_4$. Am Kollektor des Transistors $T_3$ entsteht infolge der Unterbrechung des Spulenstroms eine Spannungsspitze, welche über die Diode $D_3$ zur Ansprechstromquelle $U_1$ hin abgeleitet wird. Damit fließt die in der Spule L gespeicherte Energie in die Ansprechstromquelle $U_1$ zurück. Die Unterbrechung des Stromflusses über die Spule L gibt den beweglichen Magnetkern frei, so daß die Rückstellfeder das Magnetventil schnell schließen kann. Geeignete Dämpfungsmittel sorgen für einen vibrationsfreien Schließvorgang.

Patentansprüche:

1. Erregerschaltung zum schnellen Betätigen von Magnetventilen, d a d u r c h  g e k e n n z e i c h n e t , daß die Erregerspule (L) über zwei Schaltstrecken ($T_3$,$T_5$) nacheinander an eine den Ansprechstrom liefernde erste Stromquelle ($U_1$) und eine den Haltestrom liefernde zweite Stromquelle ($U_2$) anschließbar ist und ein Zeitgeber oder eine auf die Lage des beweglichen Magnetkerns ansprechende Fühlerschaltung die Umschaltung von der Ansprechstromquelle auf die Haltestromquelle steuert.

2. Erregerschaltung nach Anspruch 1, d a d u r c h  g e k e n n z e i c h n e t , daß der Erregerspule (L) zumindest während der Einschaltung der Ansprechstromquelle ($U_1$) eine dem Erregerstrom entgegengesetzt gepolte Freilaufdiode ($D_3$) parallelgeschaltet ist.

3. Erregerschaltung nach Anspruch 1 oder 2 , d a d u r c h  g e k e n n z e i c h n e t , daß an beiden Enden der Erregerspule (L) je eine der beiden Schaltstrecken ($T_3$, $T_5$) angeordnet ist.

4. Erregerschaltung nach einem der Ansprüche 1 bis 3 mit einseitig an Bezugspotential angeschlossener Erregerspule, d a d u r c h  g e k e n n z e i c h n e t , daß mit der zwischen den anderen Erregerspulenanschluß und die Haltestromquelle ($U_2$) eingeschalteten Schaltstrecke ($T_3$) eine in Durchlaßrichtung gepolte Diode ($D_2'$) in Reihe geschaltet ist (Fig.1).

5. Erregerschaltung nach einem der Ansprüche 1 bis 3 mit je einer Schaltstrecke an beiden Enden der Erregerspule, d a d u r c h  g e k e n n z e i c h n e t, daß der über die eine Schaltstrecke ($T_5$) an die Ansprechstromquelle ($U_1$) anschließbare Erregerspulenanschluß

über eine für den Haltestrom in Durchlaßrichtung gepolte Diode ($D_2''$) mit Bezugspotential in Verbindung steht und die Haltestromquelle ($U_2$) eine entgegengesetzte Polarität hat wie die Ansprechstromquelle ($U_1'$) (Fig.2).

6. Erregerschaltung nach einem der Ansprüche 1 bis 3, mit je einer Schaltstrecke an beiden Enden der Erregerspule, d a d u r c h   g e k e n n z e i c h n e t , daß der eine Erregerspulenanschluß über die eine Schaltstrecke ($T_3$) an Bezugspotential anschließbar ist, während der andere Erregerspulenanschluß einerseits über eine für den Haltestrom in Durchlaßrichtung gepolte Diode ($D_2$) an die Haltestromquelle ($U_2$) angeschlossen und andererseits über die andere Schaltstrecke ($T_5$) an die Ansprechstromquelle ($U_1$) anschließbar ist (Fig. 3 und 4).

7. Erregerschaltung nach einem der Ansprüche 1 bis 6, d a d u r c h   g e k e n n z e i c h n e t , daß die Schaltstrecken durch Halbleiterschalter, insbesondere die Emitter-Kollektor-Strecke von Schalttransistoren ($T_3, T_5$) oder durch Feldeffekttransistoren gebildet sind.

8. Erregerschaltung nach Anspruch 6 und 7, d a d u r c h g e k e n n z e i c h n e t , daß die Basiselektrode des der Ansprechstromquelle ($U_1$) zugewandten Schalttransistors ($T_5$) mit dem Ausgang des Zeitgebers ($C, R, T_1$) bzw. der Fühlerschaltung in Verbindung steht.

9. Erregerschaltung nach Ansprch 8, d a d u r c h   g e - k e n n z e i c h n e t , daß der Zeitgeber eine Konstantstromquelle ($T_1$) und einen Kondensator (C) aufweist, dessen eine Belegung über einen weiteren Transistor ($T_4$) mit der Basiselektrode des der Ansprechstromquelle ($U_1$) zugewandten Schalttransistors ($T_5$) in Verbindung steht.

0091648

10. Erregerschaltung nach Anspruch 9, d a d u r c h   g e - k e n n z e i c h n e t , daß der an die andere Belegung des Kondensators (C) angeschlossene Kollektor eines die Konstantstromquelle bildenden Transistors ($T_1$) über eine weitere Diode ($D_1$) an die Haltestromquelle ($U_2$) angeschlossen ist.

11. Erregerschaltung nach Anspruch 9 und 10 , d a d u r c h   g e k e n n z e i c h n e t , daß die eine Belegung des Kondensators (C) über die Parallelschaltung eines Widerstandes ($R_3$) und einer in Sperrichtung gepolten Diode ($D_4$) mit der Ansprechstromquelle ($U_1$) in Verbindung steht.

12. Erregerschaltung nach Anspruch 10 oder 11 , d a - d u r c h   g e k e n n z e i c h n e t , daß die Basis des Transistors ($T_1$) in der Konstantstromquelle als Steuereingang (Y) an den Ausgang einer die Einschaltdauer des Magnetventils bestimmenden Steuerschaltung angeschlossen ist.

13. Erregerschaltung nach einem der Ansprüche 10 bis 12, bei welcher dem die eine Schaltstrecke bildenden Transistor ($T_3$) ein weiterer Transistor ($T_2$) in Darlington-Schaltung zugeordnet ist, d a d u r c h · g e k e n n z e i c h n e t , daß die Basiselektrode des weiteren Transistors ($T_2$) über einen Widerstand ($R_5$) an den Steuereingang der Konstantstromquelle ($T_1$) angeschlossen ist, während der Kollektor des weiteren Transistors über einen Widerstand ($R_6$) mit der Haltestromquelle ($U_2$) in Verbindung steht.

14. Erregerschaltung nach einem der Ansprüche 9 bis 13, g e k e n n z e i c h n e t   d u r c h   einen zwischen die Ansprechstromquelle ($U_1$) und Bezugspotential eingeschalteten Spannungsteiler ($R_2$,$R_1$), dessen Abgriff an die andere Belegung des Kondensators (C) angeschlossen ist.

Fig.1

Fig. 2

Fig. 3

Fig.4

Fig. 5

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | DE-A-2 631 553 (SCHABLONENTECHNIK KUFSTEIN) * Seite 11, Absätze 2-5; Seite 12, Absätze 1,2 * | 1-4,6-8 | H 01 F  7/18 |
| X | FR-A-2 453 478 (ASSOCIATION DES OUVRIERS EN INSTRUMENTS DE PRECISION) * Seite 12, Zeilen 14-34; Seiten 13-16 * | 1,5 | |
| A | US-A-3 789 237 (JENOPTIK JENA) * Spalte 3, Zeilen 1-27 * | 1,3,4, 6-9 | |
| A | US-A-4 112 477 (GENERAL MOTORS) * Spalte 4, Zeilen 6-68; Spalte 5, zeilen 1-62 * | 1,3,4, 6,8,9 | |
| | | | RECHERCHIERTE SACHGEBIETE (Int. Cl. ³) |
| A | US-A-3 582 981 (BELL TELEPHONE) | | H 01 F  7/00 |
| A | US-A-3 411 045 (BAUSCH & LOMB) | | |
| A | US-A-4 310 868 (IBM) | | |

Der vorliegende Recherchenbericht wurde für alle Patentansprüche erstellt.

| Recherchenort DEN HAAG | Abschlußdatum der Recherche 12-07-1983 | Prüfer VANHULLE R. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument

EPA Form 1503 03 82